# EUROPÄISCHE PATENTSCHRIFT

(11) **EP 1 521 367 B1**
(45) Veröffentlichungstag und Bekanntmachung des Hinweises auf die Patenterteilung: **17.06.2009**
(21) Anmeldenummer: 03022099.0
(22) Anmeldetag: 02.10.2003
(51) Int. Cl.: H03K 19/0175

(54) **Halbleiter-Chip**
Semiconductor chip
Puce à semi-conducteur

(43) Veröffentlichungstag der Anmeldung: 06.04.2005
(73) Patentinhaber: Infineon Technologies AG, 81669 München (DE)
(72) Erfinder: Barrenscheen, Jens, Dr., 81669 München (DE)
(74) Vertreter: Repkow, Ines

(56) Entgegenhaltungen:
- US-A- 5 256 914
- US-A- 5 471 145
- US-A- 5 867 030
- US-A1- 2003 107 393

## Beschreibung

Die vorliegende Erfindung betrifft eine Vorrichtung gemäß dem Oberbegriff des Patentanspruchs 1, d.h. einen Halbleiter-Chip mit einer Vielzahl von Ein- und/oder Ausgabeanschlüssen, wobei den Ein- und/oder Ausgabeanschlüssen zumindest teilweise ein Eingangstreiber und ein Ausgangstreiber vorgeschaltet ist, und wobei der Eingangstreiber am zugeordneten Ein-und/oder Ausgabeanschluß anliegende Signale verstärkt und zur Weiterverarbeitung durch den Halbleiter-Chip an andere Komponenten desselben weiterleitet, und wobei der Ausgangstreiber im Halbleiter-Chip erzeugte Signale verstärkt und zur Ausgabe derselben aus dem Halbleiter-Chip an den zugeordneten Ein-und/oder Ausgabeanschluß weiterleitetet.

Ein solcher Halbleiter-Chip ist beispielsweise aus der US 5,256,914 bekannt.

Halbleiter-Chips sind integrierte Schaltungen enthaltende Vorrichtungen, die seit vielen Jahren bekannt sind und keiner näheren Erläuterung bedürfen.

Halbleiter-Chips und Halbleiter-Chips enthaltende Systeme werden für die unterschiedlichsten Zwecke eingesetzt. Hier-unter befinden sich auch sicherheitskritische Anwendungen, bei welchen es von größter Bedeutung ist, daß der Halbleiter-Chip bzw. das den Halbleiter-Chip enthaltende System unter allen Umständen fehlerfrei arbeitet. Eine solche Anwendung ist beispielsweise ein Antiblockiersystem für ein Kraftfahrzeug.

Für sicherheitskritische Anwendungen eingesetzte Halbleiter-Chips dürfen keine Fehlfunktionen aufweisen. Zumindest aber müssen gegebenenfalls auftretende Fehlfunktionen sofort erkannt und beseitigt werden, wobei das Beseitigen auch darin bestehen kann, daß der Halbleiter-Chip oder das diesen enthaltende System in einen definierten Zustand versetzt wird, in welchem durch die Fehlfunktion des Halbleiter-Chips kein Schaden verursacht werden kann.

Eine der Fehlfunktionen, die in einem Halbleiter-Chip auftreten können, besteht darin, daß kein ordnungsgemäßer Datenaustausch zwischen dem Halbleiter-Chip und den mit diesem verbundenen Komponenten des den Halbleiter-Chip enthaltenden Systems gewährleistet ist. Eine solche Fehlfunktion kann die unterschiedlichsten Ursachen haben, beispielsweise
- die nicht ordnungsgemäße Funktion der den Ein- und/oder Ausgabeanschlüssen des Halbleiter-Chips vorgeschalteten Ausgangstreiber, durch welche im Halbleiter-Chip erzeugte Signale verstärkt und zur Ausgabe derselben aus dem Halbleiter-Chip an den jeweils zugeordneten Ein- und/oder Ausgabeanschluß weitergeleitet werden,
- fehlerhafte Verbindungen zwischen den Ausgangsanschlüssen der Ausgangstreiber und den zugeordneten Ein- und/oder Ausgabeanschlüssen des Halbleiter-Chips,
- die nicht ordnungsgemäße Funktion der den Ein- und/oder Ausgabeanschlüssen des Halbleiter-Chips vorgeschalteten Eingangstreiber, durch welche an zugeordneten Ein- und/oder Ausgabeanschlüssen anliegende Signale verstärkt und zur Weiterverarbeitung durch den Halbleiter-Chip an andere Komponenten desselben weitergeleitet werden, und/oder
- fehlerhafte Verbindungen zwischen den Eingangsanschlüssen der Eingangstreiber und den zugeordneten Ein- und/oder Ausgabeanschlüssen des Halbleiter-Chips.

Die Ursache für eine Fehlfunktion des Halbleiter-Chips kann aber auch außerhalb des Halbleiter-Chips liegen. Die nicht ordnungsgemäße Ausgabe eines aus dem Halbleiter-Chips auszugebenden Signals bzw. der nicht ordnungsgemäße Empfang eines dem Halbleiter-Chip zugeführten Signals kann beispielsweise auch durch einen außerhalb des Halbleiter-Chips vorhandenen Kurzschluß verursacht werden, durch welchen ein Ein- und/oder Ausgabeanschluß des Halbleiter-Chips auf ein bestimmtes Potential gezogen wird.

Es sind bereits Möglichkeiten bekannt, um solche Fehler zu erkennen, beispielsweise der Boundary Scan gemäß IEEE 1149.1. Die bekannten Möglichkeiten zur Erkennung der genannten Fehler weisen den Nachteil auf, daß sie nur in Testphasen zum Einsatz kommen können. Solche Testphasen können zwar auch während des normalen Betriebes des Halbleiter-Chips eingefügt werden, doch muß hierfür der normale Betrieb des Halbleiter-Chips mehr oder weniger lange unterbrochen werden. Beim Einsatz des Halbleiter-Chips in einem Antiblockiersystem hätte dies zur Folge, daß das Antiblockiersystem während der Fehlererkennung inaktiv ist. Dies würde ein hohes Sicherheitsrisiko darstellen und wird daher im allgemeinen nicht praktiziert.

Der vorliegenden Erfindung liegt daher die Aufgabe zugrunde, den Halbleiter-Chip gemäß dem Oberbegriff des Patentanspruchs 1 derart weiterzubilden, daß sich die vorstehend genannten Fehler ohne eine Unterbrechung der Anwendung erkennen lassen, für welche der Halbleiter-Chip eingesetzt wird.

Diese Aufgabe wird erfindungsgemäß durch den in Patentanspruch 1 beanspruchten Halbleiter-Chip gelöst.

Der erfindungsgemäße Halbleiter-Chip zeichnet sich dadurch aus, daß der Halbleiter-Chip eine Überwachungseinrichtung enthält, durch welche die Zeit ermittelt wird, die zwischen dem Auftreten einer Flanke in dem dem Eingangsanschluß des Ausgangstreibers zugeführten Signal und dem Auftreten der entsprechenden Flanke in dem aus dem Ausgangsanschluß des Eingangstreibers ausgegebenen Signal verstreicht.

Anhand der ermittelten Zeit läßt sich zweifelsfrei feststellen, ob ein ordnungsgemäßer Datenaustausch zwischen dem Halbleiter-Chip und den mit diesem verbundenen Komponenten des den Halbleiter-Chip enthaltenden Systems gewährleistet ist.

Ist die ermittelte Zeit länger als es normalerweise der Fall ist oder sein sollte, so läßt sich daraus die Schlußfolgerung ziehen,
- daß der Ausgangstreiber nicht ordnungsgemäß arbeitet, und/oder
- daß keine ordnungsgemäße Verbindung zwischen dem Ausgangsanschluß des Ausgangstreibers und dem zugeordneten Ein-und/oder Ausgabeanschluß besteht, und/oder
- daß keine ordnungsgemäße Verbindung zwischen dem Eingangsanschluß des Eingangstreibers und dem zugeordneten Ein-und/oder Ausgabeanschluß besteht, und/oder
- daß der Eingangstreiber nicht ordnungsgemäß arbeitet, und/oder
- daß innerhalb oder außerhalb des Halbleiter-Chips ein Kurzschluß existiert, durch welchen der durch die Überwachungseinrichtung überwachte Ein- und/oder Ausgabeanschluß auf ein Potential gezogen wird, dessen Größe und/oder dessen zeitlicher Verlauf sich von der Größe und/oder vom zeitlichen Verlauf des vom Ausgangstreiber erzeugten Signals unterscheidet, und/oder
- daß der Verbraucher, der an dem durch die Überwachungseinrichtung überwachten Ein- und/oder Ausgabeanschluß angeschlossen ist, mehr Strom zieht als es bei fehlerfreiem Betrieb des Systems der Fall ist.

Ist die ermittelte Zeit kürzer als es normalerweise der Fall ist oder sein sollte, so läßt sich daraus die Schlußfolgerung ziehen,
- daß der Ausgangstreiber nicht ordnungsgemäß arbeitet, und/oder
- daß der Eingangstreiber nicht ordnungsgemäß arbeitet, und/oder
- daß zwischen dem Eingangsanschluß des Ausgangstreibers und dem Ausgangsanschluß des Eingangstreibers ein Kurzschluß existiert, und/oder
- daß der Verbraucher, der an dem durch die Überwachungseinrichtung überwachten Ein- und/oder Ausgabeanschluß angeschlossen ist, weniger Strom zieht als es bei fehlerfreiem Betrieb des Systems der Fall ist.

Sämtliche Ursachen dafür, daß die durch die Überwachungseinrichtung ermittelte Zeit kürzer oder länger als erwartet ist, sind Fehler, die die Funktion des Halbleiter-Chips oder des diesen enthaltenden Systems beeinträchtigen oder die ordnungsgemäße Funktion in Frage stellen. Eine zu lange oder zu kurze Zeit kann daher zum Anlaß genommen werden, Maßnahmen zu ergreifen, durch die verhindert wird, daß durch die Fehler größere Schäden oder Sicherheitsrisiken entstehen.

Für die Überwachung des Halbleiter-Chips bzw. des diesen enthaltenden Systems müssen - anders als etwa beim Boundary Scan nach IEEE 1149.1 - keine besonderen Testsignale verwendet werden. Die Überwachung kann unter Verwendung der Signale erfolgen die der Halbleiter-Chip während des normalen Betriebes desselben über den durch die Überwachungseinrichtung überwachten Ein- und/oder Ausgabeanschluß auszugeben hat, so daß keine Notwendigkeit besteht, die Anwendung, für die der Halbleiter-Chip eingesetzt wird, während der Überwachung zu unterbrechen.

Vorteilhafte Weiterbildungen der Erfindung sind den Unteransprüchen, der folgenden Beschreibung, und den Figuren entnehmbar.

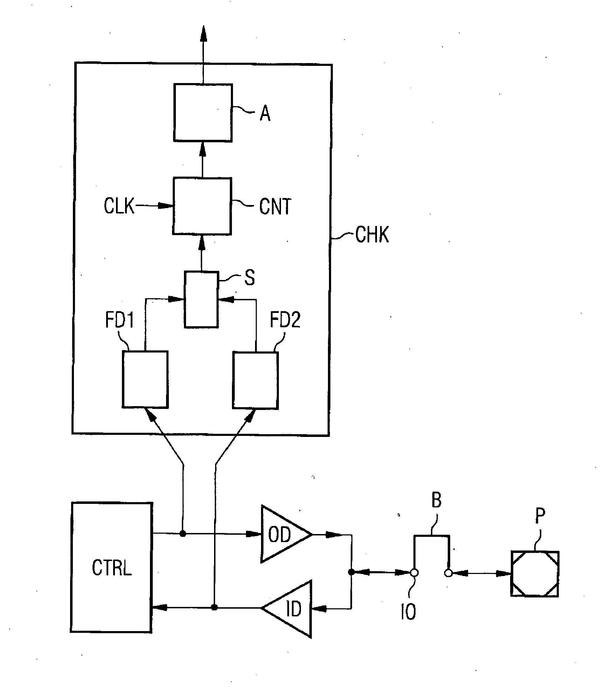

Die Erfindung wird nachfolgend anhand eines Ausführungsbeispiels unter Bezugnahme auf die Figur näher erläutert.

Die Figur zeigt Teile des im folgenden näher beschriebenen Halbleiter-Chips.

Der hier vorgestellte Halbleiter-Chip ist ein beliebiger Halbleiter-Chip. D.h., es kann sich um eine programmgesteuerte Einheit wie beispielsweise einen Mikroprozessor, Mikrocontroller, Signalprozessor oder dergleichen handeln, aber auch um einen Speicher-Chip, eine Logikschaltung, oder einen eine beliebige andere Funktion und/oder einen beliebigen anderen Aufbau aufweisenden Halbleiter-Chip handeln.

Der Vollständigkeit halber sei angemerkt, daß von dem hier vorgestellten Halbleiter-Chip nur die vorliegend besonders interessierenden Bestandteile desselben gezeigt und beschrieben sind.

Der beschriebene Halbleiter-Chip weist eine Vielzahl von Ein-und/oder Ausgabeanschlüssen auf, über welche er mit anderen Komponenten des den Halbleiter-Chip enthaltenden Systems verbindbar ist. Von diesen Ein- und/oder Ausgabeanschlüssen ist in der Figur nur ein einziger dargestellt. Die Ein- und/oder Ausgabeanschlüsse des Halbleiter-Chips werden üblicherweise als Pads bezeichnet. Der in der Figur dargestellte Pad ist dort mit dem Bezugszeichen IO bezeichnet.

Der Pad IO ist über einen Bonddraht B mit einem Pin P eines den Halbleiter-Chip in sich aufnehmenden Gehäuses verbunden. Der Vollständigkeit halber sei angemerkt, daß es sich bei dem Kontaktelement des Gehäuses, mit welchem der Pad IO verbunden ist, nicht um einen Pin handeln muß. Es kann sich beispielsweise auch um einen Ball eines BGA-Gehäuses handeln, oder um ein beliebiges anderes Kontaktelement eines sonstigen Gehäuses. Darüber hinaus besteht auch keine zwingende Notwendigkeit, den Halbleiter-Chip in einem Gehäuse unterzubringen. Halbleiter-Chips können und müssen teilweise sogar ohne Gehäuse verwendet werden (beispielsweise bei der Verwendung von Halbleiter-Chips in Chip-Karten). In diesem Fall entfallen der in der Figur dargestellte Pin P und der den Pad IO und den Pin P verbindende Bonddraht B.

Der Halbleiter-Chip enthält ferner einen dem Pad IO vorgeschalteten Ausgangstreiber OD und einen dem Pad IO vorgeschalteten Eingangstreiber ID,
- wobei der Ausgangstreiber OD dazu dient, im Halbleiter-Chip erzeugte Signale zu verstärken und über den mit dem Ausgangsanschluß des Ausgangstreibers OD verbundenen Pad IO aus dem Halbleiter-Chip auszugeben, und
- wobei der Eingangstreiber ID dazu dient, dem Halbleiter-Chip über den Pin P und dem mit diesem verbundenen Pad IO zugeführte und an den mit dem Pad IO verbundenen Eingangsanschluß des Eingangstreibers weitergeleitete Signale zu verstärken und zur Weiterverarbeitung durch den Halbleiter-Chip an andere Komponenten desselben weiterzuleiten.

Der Eingangsanschluß des Ausgangstreibers OD und der Ausgangsanschluß des Eingangstreibers ID sind im betrachteten Beispiel mit einer Steuereinrichtung CTRL verbunden, welche beispielsweise durch eine port control logic gebildet werden kann. Der Eingangsanschluß des Ausgangstreibers OD und der Ausgangsanschluß des Eingangstreibers ID könnten aber auch mit beliebigen anderen Komponenten des Halbleiter-Chips verbunden sein, wobei es sich bei diesen Komponenten auch um verschiedene Komponenten handeln kann.

Die Steuereinrichtung CTRL
- führt dem Eingangsanschluß des Ausgangstreibers OD die über den Pad IO aus dem Halbleiter-Chip auszugebenden Signale zu,
- nimmt die über den Ausgangsanschluß des Eingangstreibers ausgegebenen verstärkten Signale entgegen und leitet sie zu der diese Signale weiterverarbeitenden Komponente des Halbleiter-Chips weiter, und
- steuert den Ausgangstreiber OD und den Eingangstreiber ID.

Der Ausgangstreiber OD und der Eingangstreiber ID können so betrieben werden, daß sie gleichzeitig aktiv sind.

Die den Treibern OD und ID zugeführten Signale sowie die von den Treibern OD und ID ausgegebenen Signale sind im betrachteten Beispiel digitale Signale. Es könnte sich aber auch um analoge Signale handeln.

Der Halbleiter-Chip enthält neben den vorstehend genannten Komponenten noch eine Überwachungseinrichtung CHK, durch welche erkennbar ist, ob ein ordnungsgemäßer Datenaustausch zwischen dem Halbleiter-Chip und den mit diesem verbundenen Komponenten des den Halbleiter-Chip enthaltenden Systems gewährleistet ist.

Die Überwachungseinrichtung CHK weist zwei Eingangsanschlüsse und einen Ausgangsanschluß auf und enthält einen ersten Flankendetektor FD1, einen zweiten Flankendetektor FD2, ein Speicherelement S, einen Zähler CNT, und eine Auswertungseinrichtung A.

Von den zwei Eingangsanschlüssen der Überwachungseinrichtung ist der eine Eingangsanschluß mit dem Eingangsanschluß des Ausgangstreibers OD verbunden, und ist der andere Eingangsanschluß mit dem Ausgangsanschluß des Eingangstreibers ID verbunden.

Von den zwei Flankendetektoren FD1 und FD2 detektiert der erste Flakendetektor FD1 das Auftreten von Flanken, die in dem dem Eingangsanschluß des Ausgangstreibers OD zugeführten Signal auftreten, und detektiert der zweite Flankendetektor FD2 das Auftreten von Flanken, die in dem aus dem Ausgangsanschluß des Eingangstreibers ID ausgegebenen Signal auftreten. Im betrachteten Beispiel werden jeweils die steigenden Flanken detektiert. Die Flankendetektoren könnten aber auch die fallenden Flanken detektieren.

Das Speicherelement S wird beispielsweise durch ein Register oder ein Flip-Flop gebildet und kann durch die Flankendetektoren FD1 und FD2 beschrieben werden. Genauer gesagt ist es so, daß der Inhalt des Speicherelementes S immer dann,
- wenn der erste Flankendetektor FD1 in dem dem Ausgangstreiber OD zugeführten Signal eine steigende Flanke detektiert, durch den ersten Flankendetektor gesetzt wird, und
- wenn der zweite Flankendetektor FD2 in dem aus dem Eingangstreiber ID ausgegebenen Signal eine steigende Flanke detektiert, durch den zweiten Flankendetektor zurückgesetzt wird.

Der Zähler CNT zählt während der Zeit, die zwischen dem Auftreten einer steigenden Flanke in dem dem Ausgangstreiber OD zugeführten Signal und den darauf folgenden Auftreten einer steigenden Flanke in dem aus dem Eingangstreiber ausgegebenen Signal verstreicht, die Takte eines ihm zugeführten Taktsignals CLK. Die Frequenz dieses Taktsignals ist vorzugsweise sehr viel größer als der Reziprokwert der Zeit die zwischen dem Auftreten einer steigenden Flanke in dem dem Ausgangstreiber OD zugeführten Signal und den darauf folgenden Auftreten einer steigenden Flanke in dem aus dem Eingangstreiber ausgegebenen Signal mindestens verstreicht. Dadurch repräsentiert der Zählstand des Zählers mit hoher Genauigkeit die Zeit, die zwischen dem Auftreten einer steigenden Flanke in dem dem Ausgangstreiber OD zugeführten Signal und den darauf folgenden Auftreten einer steigenden Flanke in dem aus dem Eingangstreiber ausgegebenen Signal verstreicht. Die gemessene Zeit ist die Zeit, die das dem Eingangsanschluß des Ausgangstreiber zugeführte Signal benötigt, um durch den Ausgangstreiber OD hindurch, von dessen Ausgangsanschluß weiter zum Pad IO, von diesem weiter zum Eingangsanschluß des Eingangstreibers ID, und durch den Eingangstreiber hindurch zu laufen. Während der Zeitmessung sind sowohl der Ausgangstreiber OD als auch der Eingangstreiber ID aktiviert. Die gemessene Laufzeit hängt von den Eigenschaften der vom Signal durchlaufenen Halbleiter-Chip-Komponenten und von der äußeren Beschaltung des Halbleiter-Chips ab. Wenn der Halbleiter-Chip bzw. das den Halbleiter-Chip enthaltende System ordnungsgemäß arbeitet, weist diese Laufzeit einen bestimmten Wert auf. Umgekehrt läßt sich an größeren oder kleineren Laufzeiten erkennen, daß der Halbleiter-Chip oder das diesen enthaltende System nicht ordnungsgemäß arbeitet. Hierauf wird später noch genauer eingegangen

Die Steuerung des Zählers CNT erfolgt im betrachteten Beispiel durch den Inhalt des Speicherelementes S. Durch einen Wechsel des Speicherelementinhaltes vom niedrigen Pegel auf den hohen Pegel wird der Zähler CNT zurückgesetzt und gestartet; durch einen Wechsel des Speicherelementinhaltes vom hohen Pegel auf den niedrigen Pegel wird der Zähler CNT angehalten. Der Vollständigkeit halber sei darauf hingewiesen, daß die Steuerung des Zählers auch auf beliebige andere Art und Weise erfolgen kann. Wichtig ist nur, daß der Zähler CNT beim Auftreten einer steigenden Flanke in dem dem Ausgangstreiber OD zugeführten Signal zurückgesetzt wird und zu zählen beginnt, und daß der Zähler beim Auftreten einer fallenden Flanke in dem aus dem Eingangstreiber ausgegeben Signal den Zählvorgang beendet.

Vorzugsweise wird der Zähler CNT zusätzlich auch dann angehalten, wenn er einen Zählstand erreicht hat, der größer ist als der Zählstand, der bei ordnungsgemäßem Betrieb des Halbleiter-Chips bzw. des diesen enthaltenden Systems auftreten kann. Eine der vorhandenen Möglichkeiten hierfür besteht darin, daß der Zähler beim Auftreten eines Überlaufes des Zählers angehalten wird.

Nachdem der Zähler CNT angehalten wurde, wird durch die Auswertungseinrichtung A überprüft, ob der Zählstand des Zählers innerhalb eines bestimmten Wertebereiches liegt, wobei dieser Wertebereich vorzugsweise durch den Benutzer des Halbleiter-Chips einstellbar ist. Das Starten dieser Überprüfung wird im betrachteten Beispiel durch einen Wechsel des Speicherelementinhaltes vom hohen Pegel auf den niedrigen Pegel veranlaßt, könnte aber auch auf beliebige andere Art und Weise erfolgen.

Der erwähnte Wertebereich ist oder wird so festgelegt, daß der beim Anhalten des Zählers erreichte Zählstand
- bei ordnungsgemäßem Betrieb des Halbleiter-Chips bzw. des diesen enthaltenden Systems innerhalb dieses Wertebereiches liegt, und
- bei nicht ordnungsgemäßem Betrieb des Halbleiter-Chips bzw. des diesen enthaltenden Systems außerhalb dieses Wertebereiches liegt.

Eine derartige Festlegung des Wertebereiches ist relativ einfach möglich, weil, wie vorstehend bereits erläutert wurde, der Zählstand des Zählers eine Signallaufzeit repräsentiert, und es bekannt ist, wie groß diese Signallaufzeit bei störungsfreiem Betrieb des Halbleiter-Chips bzw. des diesen enthaltenden Systems sein sollte oder sein darf.

Somit kann am Zählstand des Zählers bzw. der dadurch repräsentierten Signallaufzeit erkannt werden, ob der Halbleiter-Chip bzw. das diesen enthaltende System ordnungsgemäß arbeitet. Wenn sich der Zählstand des Zählers außerhalb des bestimmten Wertebereiches befindet, bedeutet dies, daß die dadurch repräsentierte Signallaufzeit kürzer oder länger ist als sie sein sollte oder sein dürfte.

Mögliche Gründe dafür, daß der Zählstand die obere Grenze des bestimmten Wertebereiches überschreitet, bestehen beispielsweise darin,
- daß der Ausgangstreiber OD das ihm zugeführte Signal nicht oder nicht ausreichend stark verstärkt, und/oder
- daß keine oder keine ordnungsgemäße Verbindung zwischen dem Ausgangsanschluß des Ausgangstreibers OD und dem Pad IO besteht, und/oder
- daß keine oder keine ordnungsgemäße Verbindung zwischen dem dem Pad IO und dem Eingangsanschluß des Eingangstreibers ID besteht, und/oder
- daß der Eingangstreiber ID das ihm zugeführte Signal nicht oder nicht ausreichend stark verstärkt, und/oder
- daß innerhalb oder außerhalb des Halbleiter-Chips ein Kurzschluß existiert, durch welchen der Pad IO auf ein Potential gezogen wird, dessen Größe und/oder dessen zeitlicher Verlauf sich von der Größe und/oder vom zeitlichen Verlauf des vom Ausgangstreiber OD erzeugten Signals unterscheidet, und/oder
- daß die am Pin P angeschlossenen Komponenten des den Halbleiter-Chip enthaltenden Systems mehr Strom ziehen als es bei fehlerfreiem Betrieb des Systems der Fall ist.

Mögliche Gründe dafür, daß der Zählstand die untere Grenze des bestimmten Wertebereiches unterschreitet, bestehen beispielsweise darin,
- daß der Ausgangstreiber OD das ihm zugeführte Signal zu stark verstärkt, und/oder
- daß der Eingangstreiber ID das ihm zugeführte Signal zu stark verstärkt, und/oder
- daß zwischen dem Eingangsanschluß des Ausgangstreiber OD und dem Ausgangsanschluß des Eingangstreibers ein Kurzschluß besteht, und/oder
- daß aus dem Pad ein Strom gezogen wird, der geringer ist als es bei fehlerfreiem Betrieb des Halbleiter-Chips bzw. des diesen enthaltenden Systems der Fall ist,
wobei letzteres dadurch verursacht sein kann,
- daß die Verbindung zwischen dem Pad IO und dem Pin P unterbrochen oder beschädigt ist, und/oder
- daß die Verbindung zwischen dem Pin P und den daran angeschlossenen Komponenten den Halbleiter-Chip enthaltenden Systems unterbrochen oder beschädigt ist, und/oder
- daß die am Pin P angeschlossenen Systemkomponenten defekt oder beschädigt sind.

Folglich ist es so,
- daß dann, wenn der Zählstand des Zählers CNT außerhalb des bestimmten Wertebereiches liegt, davon ausgegangen werden kann, daß einer der vorstehend genannten Fehler im Halbleiter-Chip bzw. dem diesen enthaltenden System vorliegt, und
- daß dann, wenn der Zählstand des Zählers CNT innerhalb des bestimmten Wertebereiches liegt, davon ausgegangen werden kann, daß keiner der vorstehend genannten Fehler vorliegt.

Die Überwachungseinrichtung CHK signalisiert durch über ihren Ausgangsanschluß ausgegebene Signale oder Daten, ob der Zählstand des Zählers CNT innerhalb oder außerhalb des bestimmten Wertebereiches liegt, also ob einer der vorstehend genannten Fehler vorliegt oder nicht. Falls der Halbleiter-Chip eine programmgesteuerte Einheit wie beispielsweise ein Mikroprozessor, ein Mikrocontroller, oder ein Signalprozessor ist, oder das den Halbleiter-Chip enthaltende System eine solche programmgesteuerte Einheit enthält, kann vorgesehen werden, daß die Überwachungseinrichtung CHK immer dann, wenn der Zählstand des Zählers CNT außerhalb des bestimmten Wertebereiches liegt, ein Interrupt-Request-Signal ausgibt.

Wie auf die Erkennung eines der vorstehend genannten Fehler reagiert wird, hängt vom jeweiligen Einzelfall ab. Mögliche Reaktionen bestehen darin,
- daß dem Benutzer des Halbleiter-Chips bzw. des den Halbleiter-Chip enthaltenden Systems nur signalisiert wird, daß ein Fehler erkannt wurde, und/oder
- daß der Halbleiter-Chip oder das diesen enthaltende System in einen definierten Zustand versetzt wird, in welchem der erkannte Fehler keinen größeren Schaden verursachen kann, und/oder
- daß der Halbleiter-Chip oder das diesen enthaltende System deaktiviert wird, und/oder
- daß die Funktion des Halbleiter-Chips oder von mit diesem verbundenen Komponenten von anderen Systemkomponente oder einem redundanten System übernommen wird.

Beim vorstehend beschriebenen Halbleiter-Chip detektieren die Flankendetektoren FD1 und FD2 der Überwachungseinrichtung CHK steigende Flanken. Es dürfte einleuchten und bedarf keiner näheren Erläuterung, daß man zu dem selben oder einem vergleichbaren Ergebnis kommt, wenn Flankendetektoren verwendet werden, die fallende Flanken detektieren.

Es dürfte ferner einleuchten, daß die Überwachungseinrichtung auch bei Halbleiter-Chips zum Einsatz kommen, bei welchen über den Pad IO analoge Signale ausgegeben und empfangen werden. Die einzige Voraussetzung hierfür besteht darin, daß das über den Pad IO auszugebende Signal zumindest ab und zu einen durch einen Flankendetektor detektierbare Signalverlauf aufweist.

Durch die vorstehend beschriebene Überwachungseinrichtung CHK wird nur ein einziger Pad überwacht. Die Überwachungseinrichtung CHK kann aber auch mehrere Pads überwachen. Dies kann beispielsweise dadurch bewerkstelligt werden daß die Eingangsanschlüsse der Überwachungseinrichtung CHK über Multiplexer mit den Eingangsanschlüssen von verschiedenen Pads zugeordneten Ausgangstreibern und den Ausgangsanschlüssen von verschiedenen Pads zugeordneten Eingangstreibern verbunden sind. In diesem Fall kann durch eine entsprechende Ansteuerung der Multiplexer durch den Benutzer des Halbleiter-Chips oder des diesen enthaltenden Systems ausgewählt werden, welcher Pad durch die Überwachungseinrichtung überwacht wird.

Es ist auch möglich, durch eine Überwachungseinrichtung CHK aufeinanderfolgend verschiedene Pads zu überwachen. Dies kann beispielsweise dadurch bewerkstelligt werden, daß die erwähnten Multiplexer in regelmäßigen oder unregelmäßigen zeitlichen Abständen umgeschaltet werden, wobei das Umschalten der Pads jeweils auf gesonderte Veranlassung durch den Benutzer hin, oder automatisch durch den Halbleiter-Chip erfolgen kann.

Die Überwachung der Pads durch die Überwachungseinrichtung CHK kann während des normalen Betriebes des Halbleiter-Chips bzw. des diesen enthaltenden Systems erfolgen. Es ist nicht einmal eine Unterbrechung des Betriebes erforderlich. Um die Überprüfung durchführen zu können, müssen auch keine bestimmten Testsignale oder Testsignalverläufe verwendet werden. Es können die Signale verwendet werden, die der Halbleiter-Chip während des normalen Betriebes ausgibt.

Der beschriebene Halbleiter-Chip ermöglicht es unabhängig von den Einzelheiten der praktische Realisierung, daß sich die vorstehend genannten Fehler ohne eine Unterbrechung der Anwendung erkennen lassen, für welche der Halbleiter-Chip eingesetzt wird.

### Bezugszeichenliste

- A: Auswertungseinrichtung
- B: Bonddraht
- CHK: Überwachungseinrichtung
- CLK: Taktsignal
- CNT: Zähler
- CTRL: Steuereinrichtung
- FD1: Flankendetektor
- FD2: Flankendetektor
- ID: Eingangstreiber
- IO: Pad
- OD: Ausgangstreiber
- P: Pin
- S: Speicherelement

## Patentansprüche

1. Halbleiter-Chip mit einer Vielzahl von Ein- und/oder Ausgabeanschlüssen (IO), wobei den Ein- und/oder Ausgabeanschlüssen zumindest teilweise ein Eingangstreiber (ID) und ein Ausgangstreiber (OD) vorgeschaltet ist, und wobei der Eingangstreiber am zugeordneten Ein- und/oder Ausgabeanschluß anliegende Signale verstärkt und zur Weiterverarbeitung durch den Halbleiter-Chip an andere Komponenten desselben weiterleitet, und wobei der Ausgangstreiber im Halbleiter-Chip erzeugte Signale verstärkt und zur Ausgabe derselben aus dem Halbleiter-Chip an den zugeordneten Ein- und/oder Ausgabeanschluß weiterleitet,
**dadurch gekennzeichnet,**
**daß** der Halbleiter-Chip eine Überwachungseinrichtung (CHK) enthält, durch welche die Zeit ermittelt wird, die zwischen dem Auftreten einer Flanke in dem dem Eingangsanschluß des Ausgangstreibers zugeführten Signal und dem Auftreten der entsprechenden Flanke in dem aus dem Ausgangsanschluß des Eingangstreibers ausgegebenen Signal verstreicht

2. Halbleiter-Chip nach Anspruch 1,
**dadurch gekennzeichnet,**
**daß** während der Zeitermittlung durch die Überwachungseinrichtung (CHK) sowohl der Eingangstreiber (ID) als auch der Ausgangstreiber (OD) aktiv sind.

3. Halbleiter-Chip nach Anspruch 1 oder 2,
**dadurch gekennzeichnet,**
**daß** die Überwachungseinrichtung (CHK) einen ersten Flankendetektor (FD1) und einen zweiten Flankendetektor (FD2) enthält, wobei der erste Flankendetektor Flanken in dem dem Eingangsanschluß des Ausgangstreibers (OD) zugeführten Signal detektiert, und wobei der zweite Flankendetektor Flanken in dem aus dem Ausgangsanschluß des Eingangstreibers (ID) ausgegebenen Signal detektiert.

4. Halbleiter-Chip nach Anspruch 3,
**dadurch gekennzeichnet,**
**daß** die Flankendetektoren (FD1, FD2) steigende Flanken detektieren.

5. Halbleiter-Chip nach Anspruch 3,
**dadurch gekennzeichnet,**
**daß** die Flankendetektoren (FD1, FD2) fallende Flanken detektieren.

6. Halbleiter-Chip nach Anspruch einem der vorhergehenden Ansprüche,
**dadurch gekennzeichnet,**
**daß** die Überwachungseinrichtung (CHK) einen Zähler (CNT) enthält, der während der Zeit, die zwischen dem Auftreten einer Flanke in dem dem Ausgangstreiber (OD) zugeführten Signal und dem Auftreten der entsprechenden Flanke in dem aus dem Eingangstreiber (ID) ausgegebenen Signal verstreicht, die Takte eines dem Zähler zugeführten Taktsignals (CLK) zählt.

7. Halbleiter-Chip nach Anspruch 6,
**dadurch gekennzeichnet,**
**daß** der Zähler (CNT) beim Auftreten einer Flanke in dem dem Ausgangstreiber (OD) zugeführten Signal zurückgesetzt und gestartet wird.

8. Halbleiter-Chip nach Anspruch 6,
**dadurch gekennzeichnet,**
**daß** der Zähler (CNT) beim Auftreten einer Flanke in dem aus dem Eingangstreiber (ID) ausgegebenen Signal angehalten wird.

9. Halbleiter-Chip nach Anspruch 6,
**dadurch gekennzeichnet,**
**daß** der Zähler (CNT) durch ein 1 Bit speicherndes Speicherelement (S) gesteuert wird, wobei das im Speicherelement gespeicherte Bit beim Auftreten einer Flanke in dem dem Ausgangstreiber (OD) zugeführten Signal gesetzt, und beim Auftreten einer Flanke in dem aus dem Eingangstreiber (ID) ausgegebenen Signal zurückgesetzt wird, und wobei der Zähler durch das Setzen des im Speicherelement gespeicherten Bits zurückgesetzt und gestartet wird, und durch das Zurücksetzen des im Speicherelement gespeicherten Bits angehalten wird.

10. Halbleiter-Chip nach einem der Ansprüche 6 bis 9,
**dadurch gekennzeichnet,**
**daß** der Zähler (CNT) auch angehalten wird, wenn die durch den Zählstand des Zählers repräsentierte Zeit größer ist als die maximale Zeit, die bei einem fehlerfrei arbeitenden Halbleiter-Chip zwischen dem Auftreten einer Flanke in dem dem Ausgangstreiber (OD) zugeführten Signal und dem Auftreten einer Flanke in dem aus dem Eingangstreiber (ID) ausgegebenen Signal verstreichen kann.

11. Halbleiter-Chip nach Anspruch 10,
**dadurch gekennzeichnet,**
**daß** der Zähler beim Auftreten eines Überlaufes des Zählstandes angehalten wird.

12. Halbleiter-Chip nach einem der vorhergehenden Ansprüche,
**dadurch gekennzeichnet ,**
**daß** die Überwachungseinrichtung (CHK) eine Auswertungseinrichtung (A) enthält, durch welche überprüft wird, ob die durch den Zählstand des angehaltenen Zählers (CNT) repräsentierte Zeit innerhalb eines vorgegebenen Zeitfensters liegt.

13. Halbleiter-Chip nach Anspruch 12,
**dadurch gekennzeichnet,**
**daß** das vorgegebene Zeitfenster durch den Benutzer des Halbleiter-Chips festlegbar ist.

14. Halbleiter-Chip nach Anspruch 12,
**dadurch gekennzeichnet,**
**daß** das Zeitfenster so gewählt ist, daß die durch den Zählstand des angehaltenen Zählers repräsentierte Zeit
- bei ordnungsgemäßer Funktion des Halbleiter-Chips oder des diesen enthaltenden Systems innerhalb dieses Zeitfensters liegt, und
- bei nicht ordnungsgemäßer Funktion des Halbleiter-Chips oder des diesen enthaltenden Systems außerhalb dieses Zeitfensters liegt.

15. Halbleiter-Chip nach Anspruch 12,
**dadurch gekennzeichnet,**
**daß** das Zeitfenster durch einen Wertebereich definiert wird, der so gewählt ist, daß der Zählstand des angehaltenen Zählers (CNT)
- bei ordnungsgemäßer Funktion des Halbleiter-Chips oder des diesen enthaltenden Systems innerhalb dieses Wertebereiches liegt, und
- bei nicht ordnungsgemäßer Funktion des Halbleiter-Chips oder des diesen enthaltenden Systems außerhalb dieses Wertebereiches liegt.

16. Halbleiter-Chip nach Anspruch 12,
**dadurch gekennzeichnet,**
**daß** die Auswertungseinrichtung (A) signalisiert, wenn die durch den Zählstand des angehaltenen Zählers (CNT) repräsentierte Zeit außerhalb des vorgegebenen Zeitfensters liegt.

17. Halbleiter-Chip nach Anspruch 16,
**dadurch gekennzeichnet,**
**daß** die Signalisierung durch die Ausgabe eines Interrupt-Request-Signals erfolgt.

18. Halbleiter-Chip nach Anspruch 12,
**dadurch gekennzeichnet,**
**daß** die Auswertungseinrichtung (A) unmittelbar nach dem Anhalten des Zählers (CNT) mit der von ihr durchzuführenden Überprüfung beginnt.

19. Halbleiter-Chip nach Anspruch 18,
**dadurch gekennzeichnet,**
**daß** die Auswertungseinrichtung (A) durch das Zurücksetzen des im Speicherelement (S) gespeicherten Bits zur Durchführung der von ihr durchzuführenden Überprüfung veranlaßt wird.

20. Halbleiter-Chip nach einem der vorhergehenden Ansprüche,
**dadurch gekennzeichnet,**
**daß** die Überwachungseinrichtung (CHK) über Multiplexer mit verschiedenen Ein- und/oder Ausgabeanschlüssen (IO) zugeordneten Eingangstreibern (ID) und Ausgangstreibern (OD) verbunden ist, und daß durch eine entsprechende Ansteuerung der Multiplexer einstellbar ist, welcher Ein- und/oder Ausgabeanschluß überwacht werden soll.

21. Halbleiter-Chip nach Anspruch 20,
**dadurch gekennzeichnet,**
**daß** die Ansteuerung der Multiplexer durch den Benutzer des Halbleiter-Chips vorgebbar ist.

22. Halbleiter-Chip nach Anspruch 20,
**dadurch gekennzeichnet,**
**daß** die Multiplexer so angesteuert werden, daß aufeinanderfolgend verschiedene Ein- und/oder Ausgabeanschlüsse (IO) überwacht werden.

## Claims

1. Semiconductor chip having a multiplicity of input and/or output terminals (IO), wherein an input driver (ID) and an output driver (OD) are connected upstream of the input and/or output terminals at least in part, and wherein the input driver amplifies signals present at the assigned input and/or output terminal and forwards them for further processing by the semiconductor chip to other components thereof, and wherein the output driver amplifies signals generated in the semiconductor chip and forwards them to the assigned input and/or output terminal for outputting them from the semiconductor chip,
**characterized**
**in that** the semiconductor chip contains a monitoring device (CHK), which determines the time that elapses between the occurrence of an edge in the signal fed to the input terminal of the output driver and the occurrence of the corresponding edge in the signal output from the output terminal of the input driver.

2. Semiconductor chip according to Claim 1,
**characterized**
**in that** both the input driver (ID) and the output driver (OD) are active during the time determination by the monitoring device (CHK).

3. Semiconductor chip according to Claim 1 or 2,
**characterized**
**in that** the monitoring device (CHK) contains a first edge detector (FD1) and a second edge detector (FD2), wherein the first edge detector detects edges in the signal fed to the input terminal of the output driver (OD) and wherein the second edge detector detects edges in the signal output from the output terminal of the input driver (ID).

4. Semiconductor chip according to Claim 3,
**characterized**
**in that** the edge detectors (FD1, FD2) detect rising edges.

5. Semiconductor chip according to Claim 3,
**characterized**
**in that** the edge detectors (FD1, FD2) detect falling edges.

6. Semiconductor chip according to any of the preceding claims,
**characterized**
**in that** the monitoring device (CHK) contains a counter (CNT), which, during the time that elapses between the occurrence of an edge in the signal fed to the output driver (OD) and the occurrence of the corresponding edge in the signal output from the input driver (ID), counts the clock cycles of a clock signal (CLK) fed to the counter.

7. Semiconductor chip according to Claim 6,
**characterized**
**in that** the counter (CNT) is reset and started upon the occurrence of an edge in the signal fed to the output driver (OD).

8. Semiconductor chip according to Claim 6,
**characterized**
**in that** the counter (CNT) is stopped upon the occurrence of an edge in the signal output from the input driver (ID).

9. Semiconductor chip according to Claim 6,
**characterized**
**in that** the counter (CNT) is controlled by a storage element (S) that stores 1 bit, wherein the bit stored in the storage element is set upon the occurrence of an edge in the signal fed to the output driver (OD) and is reset upon the occurrence of an edge in the signal output from the input driver (ID), and wherein the counter is reset and started by the setting of the bit stored in the storage element and is stopped by the resetting of the bit stored in the storage element.

10. Semiconductor chip according to any of Claims 6 to 9,
**characterized**
**in that** the counter (CNT) is also stopped if the time represented by the count of the counter is greater than the maximum time that can elapse, in the case of a semiconductor chip operating without any faults, between the occurrence of an edge in the signal fed to the output driver (OD) and the occurrence of an edge in the signal output from the input driver (ID).

11. Semiconductor chip according to Claim 10,
**characterized**
**in that** the counter is stopped when an overflow of the count occurs.

12. Semiconductor chip according to any of the preceding claims,
**characterized**
**in that** the monitoring device (CHK) contains an evaluation device (A), which checks whether the time represented by the count of the stopped counter (CNT) lies within a predetermined time window.

13. Semiconductor chip according to Claim 12,
**characterized**
**in that** the predetermined time window can be defined by the user of the semiconductor chip.

14. Semiconductor chip according to Claim 12,
**characterized**
**in that** the time window is chosen in such a way that the time represented by the count of the stopped counter
- lies within said time window in the event of proper functioning of the semiconductor chip or of the system containing the latter, and
- lies outside said time window in the event of improper functioning of the semiconductor chip or of the system containing the latter.

15. Semiconductor chip according to Claim 12,
**characterized**
**in that** the time window is defined by a range of values chosen such that the count of the stopped counter (CNT)
- lies within said range of values in the event of proper functioning of the semiconductor chip or of the system containing the latter, and
- lies outside said range of vales in the event of improper functioning of the semiconductor chip or of the system containing the latter.

16. Semiconductor chip according to Claim 12,
**characterized**
**in that** the evaluation device (A) signals if the time represented by the count of the stopped counter (CNT) lies outside the predetermined time window.

17. Semiconductor chip according to Claim 16,
**characterized**
**in that** the signalling is effected by the outputting of an interrupt request signal.

18. Semiconductor chip according to Claim 12,
**characterized**
**in that** the evaluation device (A) begins the checking that is to be carried out by it directly after the stopping of the counter (CNT).

19. Semiconductor chip according to Claim 18,
**characterized**
**in that** the evaluation device (A) is caused to carry out the checking that is to be carried out by it as a result of the resetting of the bit stored in the storage element (S).

20. Semiconductor chip according to any of the preceding claims,
**characterized**
**in that** the monitoring device (CHK) is connected via multiplexers to input drivers (ID) and output drivers (OD) assigned to different input and/or output terminals (IO), and
**in that** corresponding driving of the multiplexers makes it possible to set which input and/or output terminal is intended to be monitored.

21. Semiconductor chip according to Claim 20,
**characterized**
**in that** the driving of the multiplexers can be predetermined by the user of the semiconductor chip.

22. Semiconductor chip according to Claim 20,
**characterized**
**in that** the multiplexers are driven in such a way that successively different input and/or output terminals (IO) are monitored.

## Revendications

1. Puce semi-conductrice qui présente plusieurs bornes d'entrée et/ou plusieurs bornes de sortie (IO), au moins certaines des bornes d'entrée et/ou des bornes de sortie étant précédées par un pilote d'entrée (ID) ou par un pilote de sortie (OD), le pilote d'entrée amplifiant les signaux appliqués sur la borne d'entrée et/ou sur la borne de sortie associées et les transférant à d'autres composants de la puce semi-conductrice pour que celle-ci poursuive le traitement, le pilote de sortie amplifiant les signaux formés dans la puce semi-conductrice et les transférant à la borne d'entrée et/ou à la borne de sortie associées pour que la puce semi-conductrice les délivre,
**caractérisée en ce que**
la puce semi-conductrice contient un dispositif de surveillance (CHK) qui détermine le temps qui s'écoule entre l'apparition d'un flanc dans le signal apporté à la borne d'entrée du pilote de sortie et l'apparition du flanc correspondant dans le signal délivré par la borne de sortie du pilote d'entrée.

2. Puce semi-conductrice selon la revendication 1, **caractérisée en ce que** tant le pilote d'entrée (ID) que le pilote de sortie (OD) sont actifs pendant la détermination du temps par le dispositif de surveillance (CHK).

3. Puce semi-conductrice selon les revendications 1 ou 2, **caractérisée en ce que** le dispositif de surveillance (CHK) contient un premier détecteur de flanc (FD1) et un deuxième détecteur de flanc (FD2), le premier détecteur de flanc détectant les flancs dans le signal apporté à la borne d'entrée du pilote de sortie (OD) et le deuxième détecteur de flanc détectant les flancs dans le signal délivré par la borne de sortie du pilote d'entrée (ID).

4. Puce semi-conductrice selon la revendication 3, **caractérisée en ce que** les détecteurs de flanc (FD1, FD2) détectent les flancs montants.

5. Puce semi-conductrice selon la revendication 3, **caractérisée en ce que** les détecteurs de flanc (FD1, FD2) détectent les flancs descendants.

6. Puce semi-conductrice selon l'une des revendications précédentes, **caractérisée en ce que** le dispositif de surveillance (CHK) contient un compteur (CNT) qui compte les cadences d'un signal de cadençage (CLK) apporté au compteur pendant la durée qui s'étend entre l'apparition d'un flanc dans le signal apporté au pilote de sortie (OD) et l'apparition du flanc correspondant dans le signal délivré par le pilote d'entrée (ID).

7. Puce semi-conductrice selon la revendication 6, **caractérisée en ce que** le compteur (CNT) est réarmé et lancé lors de l'apparition d'un flanc dans le signal apporté au pilote de sortie (OD).

8. Puce semi-conductrice selon la revendication 6, **caractérisée en ce que** le compteur (CNT) est arrêté lors de l'apparition d'un flanc dans le signal délivré par le pilote d'entrée (ID).

9. Puce semi-conductrice selon la revendication 6, **caractérisée en ce que** le compteur (CNT) est commandé par un élément de mémoire (S) qui conserve 1 bit, le bit conservé dans l'élément de mémoire étant placé lors de l'apparition d'un flanc dans le signal apporté au pilote de sortie (OD) et étant retiré lors de l'apparition d'un flanc dans le signal délivré par le pilote d'entrée (ID), le compteur étant réarmé et lancé par le placement du bit conservé dans l'élément de mémoire et étant arrêté par le retrait du bit conservé dans l'élément de mémoire.

10. Puce semi-conductrice selon l'une des revendications 6 à 9, **caractérisée en ce que** le compteur (CNT) est également arrêté si la durée représentée par l'état de comptage du compteur est supérieure à la durée maximale qui peut s'écouler dans une puce semi-conductrice qui travaille sans défaut entre l'apparition d'un flanc dans le signal apporté au pilote de sortie (OD) et l'apparition d'un flanc dans le signal délivré par le pilote d'entrée (ID).

11. Puce semi-conductrice selon la revendication 10, **caractérisée en ce que** le compteur est arrêté lors de l'apparition d'un dépassement dans l'état de comptage.

12. Puce semi-conductrice selon l'une des revendications précédentes, **caractérisée en ce que** le dispositif de surveillance (CHK) contient un dispositif d'évaluation (A) qui vérifie si la durée représentée par l'état de comptage du compteur (CNT) arrêté est située à l'intérieur d'une fenêtre temporelle prédéterminée.

13. Puce semi-conductrice selon la revendication 12, **caractérisée en ce que** la fenêtre temporelle prédéterminée peut être définie par l'utilisateur de la puce semi-conductrice.

14. Puce semi-conductrice selon la revendication 12, **caractérisée en ce que** la fenêtre temporelle est sélectionnée de telle sorte que la durée représentée par l'état de comptage du compteur arrêté :
- est située à l'intérieur de cette fenêtre temporelle lorsque la puce semi-conductrice ou le système qui la contient fonctionnent correctement et
- est située à l'extérieur de cette fenêtre temporelle lorsque la puce semi-conductrice ou le système qui la contient ne fonctionnent pas correctement.

15. Puce semi-conductrice selon la revendication 12, **caractérisée en ce que** la fenêtre temporelle est définie par une plage de valeurs sélectionnée de telle sorte que l'état de comptage du compteur (CNT) arrêté :
- est situé à l'intérieur de cette plage de valeurs lorsque la puce semi-conductrice ou le système qui la contient fonctionnent correctement et
- est situé à l'extérieur de cette plage de valeurs lorsque la puce semi-conductrice ou le système qui la contient ne fonctionnent pas correctement.

16. Puce semi-conductrice selon la revendication 12, **caractérisée en ce que** le dispositif d'évaluation (A) signale si la durée représentée par l'état de comptage du compteur (CNT) arrêté est située à l'extérieur de la fenêtre temporelle prédéterminée.

17. Puce semi-conductrice selon la revendication 16, **caractérisée en ce que** la signalisation s'effectue par émission d'un signal de requête d'interruption.

18. Puce semi-conductrice selon la revendication 12, **caractérisée en ce que** le dispositif d'évaluation (A) commence la vérification qu'il doit exécuter immédiatement après l'arrêt du compteur (CNT).

19. Puce semi-conductrice selon la revendication 18, **caractérisée en ce que** le dispositif d'évaluation (A) est amené à exécuter la vérification qu'il doit exécuter suite au retrait du bit conservé dans l'élément de mémoire (S).

20. Puce semi-conductrice selon l'une des revendications précédentes, **caractérisée en ce que** le dispositif de surveillance (CHK) est relié par des multiplexeurs à différents pilotes d'entrée (ID) et pilotes de sortie (OD) associés respectivement aux bornes d'entrée et/ou aux bornes de sortie (IO) et **en ce qu'**une commande appropriée du multiplexeur permet de définir quelle borne d'entrée et/ou quelle borne de sortie doivent être surveillées.

21. Puce semi-conductrice selon la revendication 20, **caractérisé en ce que** la commande des multiplexeurs peut être définie par l'utilisateur de la puce semi-conductrice.

22. Puce semi-conductrice selon la revendication 20, **caractérisée en ce que** les multiplexeurs sont commandés de manière à surveiller successivement différentes bornes d'entrée et/ou différentes bornes de sortie (IO).
